# EUROPEAN PATENT APPLICATION

(11) **EP 1 385 220 A2**
(43) Date of publication of application: **28.01.2004**
(21) Application number: 03254198.9
(22) Date of filing: 01.07.2003
(51) Int. Cl.: H01L 51/20

(54) **Organic semiconductor device**

(30) Priority: 17.07.2002 JP 2002208212
(71) Applicant: Pioneer Corporation, Meguro-ku, Tokyo (JP)
(72) Inventor: Tanabe, Takahisa, Tsurugashima-shi, Saitama 350-2288 (JP)
(74) Representative: Luckhurst, Anthony Henry William

(57) **Abstract**

An organic semiconductor device includes an organic semiconductor layer 13 deposited between a first electrode 11 and a second electrode 15 which are facing each other. The first and second electrodes 11, 15 are made of materials having different work functions with respect to each other.

## Description

### BACKGROUND OF THE INVENTION

### 1. Field of the Invention

The present invention relates to an organic semiconductor device which comprises an organic semiconductor layer of an organic compound.

### 2. Description of the Related Art

An inorganic semiconductor, e.g., silicon plays a major role in semiconductor devices, since certain functions such as high carrier mobility are required for semiconductors used as a diode, a switching device for signal processing, and an amplifying transistor.

In the field of organic semiconductors which utilizes an organic compound with carrier mobility, an organic electroluminescence device utilizing a photoelectric conversion feature is under development. Furthermore, application of a voltage across the organic semiconductor thin-film increases carrier density, which permits flow of an electrical current between a pair of electrodes provided on an organic semiconductor thin-film. For example, switching over the electrical current that flows in a direction of the organic semiconductor thin-film can be achieved, by means of a source electrode and a drain electrode provided on the organic semiconductor thin-film, and by means of the gate electrode provided therebetween so as to apply a voltage across a thickness direction of the thin-film. Accordingly, research has been conducted on an organic transistor, which permits a gradual utilization of the organic semiconductors in technical fields such as transmitting, processing, and recording and displaying of information. In such technical fields, an electrical signal is used for controlling electron carriers and hole carriers within the organic semiconductor at a junction interface between a metal and an organic semiconductor or between one organic semiconductor and another organic semiconductor.

Structure of, for example, an organic MOS-TFT using an organic semiconductor thin-film can be provided by, for example, a bottom-contact type and a top-contact type MOS-TFT. Each structure comprises a gate electrode, a gate insulator layer, a source electrode and a drain electrode, and an organic semiconductor layer, which are formed on a substrate. Layered structure which comprising the organic semiconductor layer by using pentacene or the like, and the gate insulator layer by using PMMA, cyclohexene or the like is proposed, because enhancement of the carrier mobility is necessary to increase a working frequency of the organic transistor. Materials used for the electrodes are Pd, Au and the like for both the source electrode and the drain electrode.

### SUMMARY OF THE INVENTION

It is therefore an object of the present invention to provide an organic semiconductor device having excellent features.

An organic semiconductor device according to the present invention includes an organic semiconductor layer deposited between a first electrode and a second electrode which are facing each other. The first and second electrodes are made of materials having different work functions with respect to each other.

### BRIEF DESCRIPTION OF THE DRAWINGS

Figure 1 is a cross sectional view showing an organic transistor according to an embodiment of the present invention;
Figure 2 is a cross sectional view showing an organic transistor according to another embodiment of the present invention;
Figure 3 is a figure showing an energy level of an organic semiconductor device;
Figure 4 is a cross sectional view showing an organic transistor according to another embodiment of the present invention;
Figure 5 is a cross-sectional view showing substrate structure of a display apparatus when an organic transistor according to another embodiment of the present invention is adapted to a TFT-organic electroluminescence display apparatus; and
Figures 6-8 are cross sectional views each showing organic transistors according to the other embodiments of the present invention.

### DETAILED DESCRIPTION OF THE INVENTION

Embodiments of organic transistors as examples of organic semiconductor devices according to the present invention will be described with reference to the drawings.

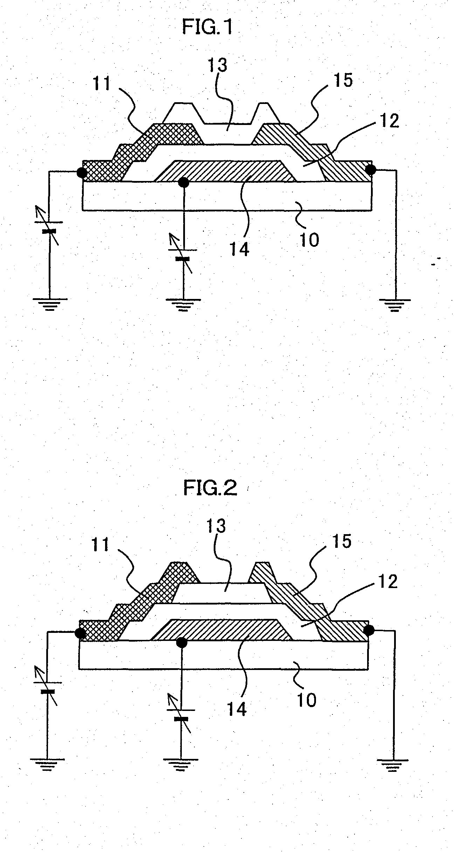

Figure 1 shows a bottom-contact type organic transistor which uses a P-type organic semiconductor according to the embodiment of the invention. The organic transistor includes a gate electrode 14 formed on a substrate 10, a gate insulator layer 12 formed thereon, an organic semiconductor layer 13 formed thereon which is made of organic compound having hole carrier mobility such as pentacene which is a P-type organic semiconductor, and a source electrode 11 as a first electrode and a drain electrode 15 as a second electrode which are both formed so as to contact the organic semiconductor layer 13. The substrate 10 is made of material having an insulating property such as glass. The gate electrode 14 applies a voltage to the organic semiconductor layer 13 which is provided between the source electrode 11 and the drain electrode 15 facing each other.

Figure 2 shows a top-contact type organic transistor according to another embodiment of the invention. Structure of the top-contact type organic transistor is the same as that of the bottom-contact type shown in Figure 1 except for the configuration in which the organic semiconductor layer 13 is firstly deposited, thereafter the source electrode 11 and the drain electrode 15 are formed thereon.

The organic semiconductor layer 13 is made of an organic compound that has a capability to transport holes or electrons when a voltage is applied thereto. The organic semiconductor layer 13 may also have a multilayered structure which comprises thin-films of organic compounds each having a carrier transporting capability. A fused ring such as anthracene or tetracene can be alternatively used for the organic semiconductor in addition to pentacene having a higher carrier mobility.

An elemental metal normally used for electrode such as Al, Cu, Ni or Cr, or an alloy thereof is used for the gate electrode 14, when the gate electrode is configured to apply a voltage via the gate insulator layer 12.

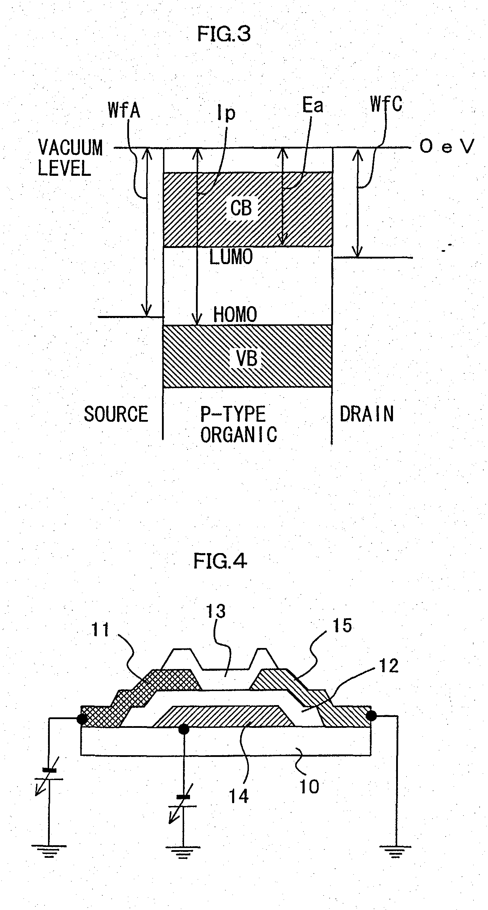

As shown in Figure 3, it is required that a work function of material used for the source electrode 11 is close to or higher than an ionization potential of the organic semiconductor layer 13, in order to decrease an electron injection barrier between the source electrode and the organic semiconductor. For example, a metal or an alloy layer having the work function close to the ionization potential of the organic semiconductor is used for the source electrode 11. It is required that a work function of material used for the drain electrode 15 is lower than the ionization potential of the organic semiconductor layer 13, in order to decrease the electron injection barrier between the drain electrode and the organic semiconductor. Accordingly, a metal or an alloy layer having the work function lower than the ionization potential of the organic semiconductor is used for the drain electrode 15.

The source electrode 11 as the first electrode has a higher work function than the drain electrode 15 as the second electrode. As shown in Figure 3, an electron affinity Ea represents energy measured between a vacuum level corresponding to a base energy level of 0eV and a Lowest Unoccupied Molecular Orbital (LUMO) level corresponding to a lowest level of a conduction band CB. The ionization potential Ip represents energy measured between the vacuum level and a High Occupied Molecular Orbital (HOMO) level corresponding to a highest level of a valence band VB. The work functions WfA and WfC of the source electrode 11 as the first electrode and the drain electrode 15 as the second electrode respectively represent energies measured between the vacuum level of 0eV and the Fermi levels.

Material having a higher work function WfA is preferable for the source electrode 11 that corresponds to the first electrode for the P-type organic semiconductor device according to the embodiment. Such material is a metal such as gold with 4. 5eV or more, platinum, palladium, chromium, selenium or nickel, indium tin oxide that is known as ITO, indium zinc oxide that is known as IZO, zinc oxide and an alloy thereof, stannic oxide, copper iodide, or the like. Material such as a metal or an alloy which includes at least one material having a work function close to the ionization potential of the organic semiconductor is used for the source electrode 11 that corresponds to the first electrode. The work function of the material included in the first electrode is preferably within a range of ± 1eV, and more preferably within a range of ± 0.5eV with a center of the range corresponding to the ionization potential of the organic semiconductor to be utilized.

When, for example, pentacene that is a carrier transporting material exhibiting high hole mobility with an ionization potential at 5.06eV is used, the work function of the material included in the source electrode 11 as the first electrode is preferably within the range from 4.56 to 5.56eV. Examples of metals satisfying the above property are Rh, Ir, Ni, Pd, Pt, Au, As, Se, Te and the like. An elemental metal described above or an alloy made from a plurality of such metals can be utilized for the first electrode. It should be noted that electrically conductive polymers such as poly(3-methylthiophene), polyphenylene sulfide, and polyaniline can also be used for the electrode. These polymers can be used by forming a single layer or by forming two or more layers of different types such as polyaniline deposited on ITO.

On the other hand, a metal or a compound having a lower work function WfC than WfA such as a metal of silver with less than 4.5eV, plumbum, stannum, aluminum, calcium, indium or the like, alkali metal such as lithium, alkali-earth metal such as magnesium, an alloy thereof, alkali metal compound, or alkali-earth metal compound is used for the drain electrode 15 corresponding to the second electrode. Material such as a metal or an alloy which includes at least one material having a work function lower than the ionization potential of the organic semiconductor is used for the drain electrode 15 corresponding to the second electrode.

When the carriers within the organic semiconductor layer are holes, material having a hole transporting property or material having a transporting property for both holes and carriers is necessary for the organic semiconductor such that the holes can be moved therethrough. In this instance, the P-type device having a hole transporting property can be achieved by using pentacene as the organic semiconductor layer as described in the above embodiment. Whereas, when the carriers are electrons, electron transporting material or material having a transporting property for both holes and carriers is necessary such that the electrons can be moved therethrough. Material having a hole transporting property or material having a transporting property for both holes and carriers can be copper-phthalocyanine or the like, and electron transporting material can be tris-8-hydroxyqunoline aluminum or the like. When an N-type organic semiconductor layer comprising the electron transporting material is formed on the gate electrode 14 that is provided on the substrate 10 having an insulating property via the gate insulator layer 12 as shown in Figure 4, an N-type device having an electron transporting property can be provided. Material such as a metal or an alloy which includes at least one material having a work function close to the electron affinity of the organic semiconductor is used for the source electrode 11 corresponding to the first electrode for the N-type device. The work function of the material included in the first electrode is preferably within a range of ± 1eV, and more preferably within a range of ± 0.5eV with a center of the range corresponding to the electron affinity of the organic semiconductor to be utilized. Material such as a metal or an alloy which includes at least one material having a work function higher than the electron affinity of the organic semiconductor is used for the drain electrode 15 corresponding to the second electrode for the N-type device. A channel is formed when a voltage applied to the gate electrode of the N-type device exceeds a threshold value, thus electrons are injected from the source electrode 11 into the N-type organic semiconductor layer, as a result, electrons flow as an electric current.

The organic semiconductor layer used for the organic semiconductor device according to the present invention may be deposited by a method such as vacuum deposition, spin coating, sputtering, or a sol-gel method. A deposition method for the source electrode and the drain electrode can be selected from the methods of vapor deposition, sputtering, and CVD. Among the methods, sputtering is preferable from the viewpoints of easy use of material, stability of formation ratio in electrode alloying, and simplicity of the deposition facility.

Although a triple-pole organic transistor having a source electrode, a drain electrode and a gate electrode has been described in the above embodiments, the present invention also maybe adapted to electrodes for a double-pole organic transistor. In addition to the embodiments shown in Figures 1 and 2, the present invention can alternatively be adapted to organic semiconductor devices having arbitrary structure which provides a channel for carriers to flow in the order of the source electrode, the organic semiconductor, and the drain electrode.

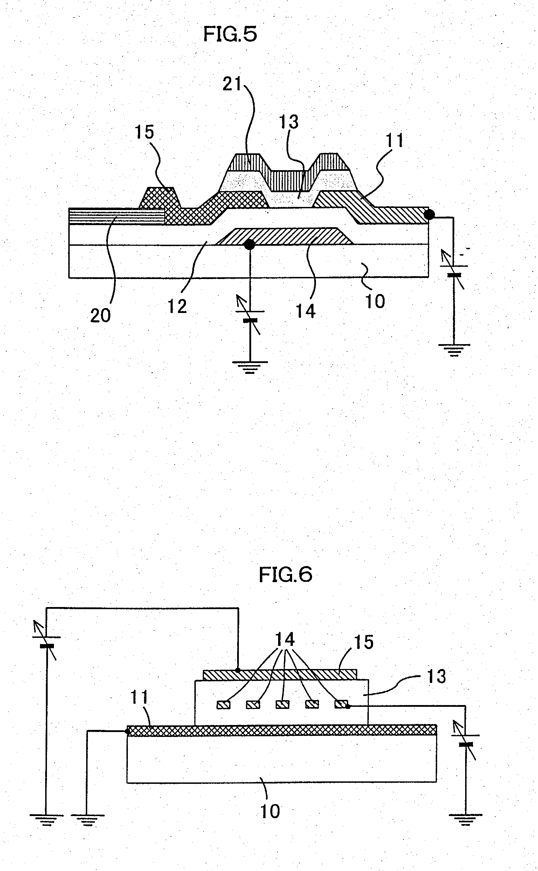

Although the aforementioned embodiments has been described regarding the fabrication of a single piece TFT, the TFT according to the present invention may be adapted, for example, to driving of pixels for a display apparatus such as an LCD or an organic electroluminescence device. Specifically, an active driving type display apparatus using the organic MOS-TFT according to the present invention can be provided by forming at least one organic transistor according to the present invention, other necessary devices such as a condenser, pixel electrodes, and the like on a common substrate. As an example, substrate structure of a display apparatus that applies features of the present invention to a TFT-organic electroluminescence display apparatus is shown in Figure 5. Structure of the TFT-organic electroluminescence display apparatus is the same as that of the embodiment shown in Figure 1 except for the configuration that the drain electrode 15 is connected to a pixel electrode 20 of a organic electroluminescence device and the organic semiconductor layer 13 is covered with a protective layer 21.

Furthermore, feature of the present invention can be adapted to a SIT (Static Induction Transistor) as an organic transistor having a vertical structure as shown in Figure 6. The SIT has a capability to switch over an electrical current that flows in a direction of layer thickness of the organic semiconductor layer 13 which sandwiches the organic semiconductor layer 13 by the source electrode 11 and the drain electrode 15 having different work functions with respect to each other. The SIT has a triple-terminal structure which includes porous gate electrodes 14 implanted at the middle of the organic semiconductor layer 13 in a thickness direction having a shape such as a lattice, comb, or rattan blind. An electrical current between the drain and the source can be controlled by means of a depletion layer generated within the organic semiconductor around the gate electrodes. The depletion layer is generated when a voltage is applied to the gate electrode 14.

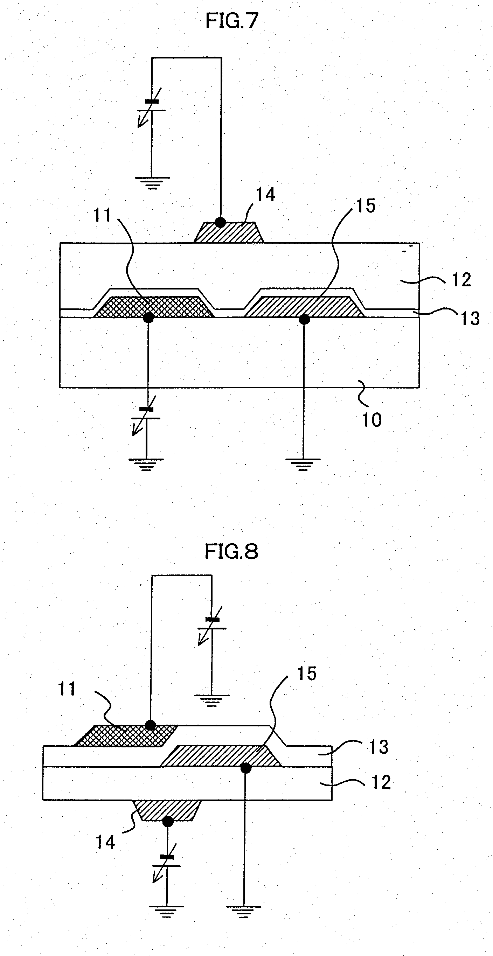

Alternatively, as shown in Figure 7, the organic transistor may have a structure comprising the gate electrode 14, and the source electrode 11 and the drain electrode 15, which are laminated with respect to each other. The source electrode 11 and the drain electrode 15 which are respectively made of alloy layers of a first metal and a second metal are formed on the substrate 10, and thereafter, the organic semiconductor layer 13, the gate insulator layer 12, and the gate electrode 14 are formed in the described order, which is the reverse order of the configuration shown in Figure 1.

In a similar manner, as shown in Figure 8, the organic transistor may have a structure such that the source electrode 11 and the drain electrode 15 having different work functions with respect to each other are formed so as to sandwich the organic semiconductor layer 13 therebetween, and the gate electrode 14 is formed so as to be spaced apart therefrom via the gate insulator layer 12.

As described above, the organic semiconductor device according to the embodiment provides first and second electrodes having work functions close to the ionization potential or the electron affinity of the organic semiconductor, so that the work functions of the materials for the electrodes become suitable with respect to a direction relating to a carrier movement, thereby realizing an organic semiconductor device having an excellent electrical feature of lower electron injection barrier to the organic semiconductor.

## Claims

1. An organic semiconductor device comprising an organic semiconductor layer deposited between a first electrode and a second electrode which are facing each other, wherein the first and second electrodes are made of materials having different work functions with respect to each other.

2. The organic semiconductor device according to claim 1, wherein the organic semiconductor layer is a P-type semiconductor.

3. The organic semiconductor device according to claim 2, wherein the first electrode has a higher work function than the second electrode.

4. The organic semiconductor device according to claim 1 or 2, wherein the first electrode has a work function that is close to an ionization potential of the organic semiconductor layer.

5. The organic semiconductor device according to claim 4, wherein the first electrode has a work function within a range from -1eV to +1eV with a center of the range corresponding to an ionization potential of the organic semiconductor layer.

6. The organic semiconductor device according to claim 4, wherein the first electrode has a work function within a range from -0.5eV to +0.5eV with a center of the range corresponding to an ionization potential of the organic semiconductor layer.

7. The organic semiconductor device according to claim 1, wherein the organic semiconductor layer is an N-type semiconductor.

8. The organic semiconductor device according to claim 7, wherein the first electrode has a lower work function than the second electrode.

9. The organic semiconductor device according to claim 8, wherein the first electrode has a work function that is close to an electron affinity of the organic semiconductor layer.

10. The organic semiconductor device according to claim 9, wherein the first electrode has a work function within a range from -1eV to +1eV with a center of the range corresponding to an electron affinity of the organic semiconductor layer.

11. The organic semiconductor device according to claim 9, wherein the first electrode has a work function within a range from -0.5eV to +0.5eV with a center of the range corresponding to an electron affinity of the organic semiconductor layer.

12. The organic semiconductor device according to any one of claims 1 to 11, wherein the first and second electrodes are a source electrode and a drain electrode, and the organic semiconductor layer is deposited such that a channel can be formed between the source electrode and drain electrode, and the device further includes a gate electrode which applies a voltage to the organic semiconductor layer provided between the source electrode and drain electrode.

13. The organic semiconductor device according to claim 12, wherein the device includes a gate insulator layer which electrically insulates the gate electrode from the source electrode and drain electrode.

14. The organic semiconductor device according to claim 13, wherein the source electrode and drain electrode are both provided on one side of the organic semiconductor layer.

15. The organic semiconductor device according to claim 13, wherein the source electrode and drain electrode are respectively provided on opposite sides of the organic semiconductor layer with respect to each other so as to sandwich the layer therebetween.

16. The organic semiconductor device according to any one of claims 1 to 11, wherein the first and second electrodes are a source electrode and a drain electrode, and the organic semiconductor layer is deposited in a layer thickness direction such that the source electrode and a drain electrode sandwich the layer therebetween, and the device includes a gate electrode which is implanted within the organic semiconductor layer.

17. The organic semiconductor device according to claim 16, wherein the gate electrode implanted within the organic semiconductor layer has one of a lattice, comb, or rattan blind shape.
